# EUROPEAN PATENT APPLICATION

(11) **EP 2 784 921 A1**
(43) Date of publication of application: **01.10.2014**
(21) Application number: 12851557.4
(22) Date of filing: 12.10.2012
(51) Int. Cl.: H02M 1/08

(54) **INVERTER DEVICE**

(30) Priority: 22.11.2011 JP 2011254698
(71) Applicant: Hitachi, Ltd., Tokyo 100-8280 (JP)
(72) Inventor: KATOH, Kaoru, Tokyo 100-8280 (JP); ISCHIKAWA, Katsumi, Tokyo 100-8280 (JP); OGAWA, Kazutoshi, Tokyo 100-8280 (JP)
(74) Representative: MERH-IP Matias Erny Reichl Hoffmann
(86) International application number: PCT/JP2012/076379
(87) International publication number: WO 2013/077105

(57) **Abstract**

In a switching circuit (inverter device) in which a power semiconductor switching element and a unipolar type diode are connected in parallel, the noise due to ringing is reduced. When the main circuit current flowing in the main circuit 19 is equal to or less than a predetermined value, an Si-IGBT 12 is switched and driven by a gate resistance 12g. In this case, when the main circuit current detected by the main circuit current detection current transformer 18 is equal to or more than a threshold value, a main circuit current detection circuit 50 changes a gate resistance switching pMOS 33 from ON state to OFF state. Accordingly, the Si-IGBT 12 operates with a summation of a gate resistance 12g and a gate resistor 31. More specifically, a gate resistance value of a gate drive circuit of the Si-IGBT 12 increases. Therefore, dv/dt of the collector-emitter voltage of the Si-IGBT 12, i.e., the recovery dv/dt of the unipolar type diode 14, is small, and therefore, the noise due to ringing can be reduced.

## Description

### Technical Field

The present invention relates to an inverter device having a semiconductor module in which a semiconductor switching element and a diode are connected in an antiparallel manner, and more particularly, to an inverter device which drives, using the gate, a power semiconductor module in which a power semiconductor switching element is connected in antiparallel to a diode which is a unipolar device made of a wide gap semiconductor such as silicon carbide and gallium nitride.

### Background Art

In recent years, semiconductor elements using materials such as silicon carbide (hereinafter referred to as SiC) and gallium nitride (hereinafter referred to as GaN) as a wide gap semiconductor element in which the width of the band gap area having no electrons is wide are attracting attention. These materials have breakdown voltage strengths about ten times as high as that of silicon (hereinafter referred to as Si) used as a material of a generally-available semiconductor element. Therefore, in the wide gap semiconductor element, the drift layer for ensuring the breakdown voltage can be made thinner to be about 1/10 of that of a generally-available semiconductor element using Si, and therefore, a power device can achieve a low ON-voltage. Accordingly, the wide gap semiconductor element using SiC and the like can use a unipolar element even in a high breakdown area where only a bipolar element can be used in a case of a semiconductor element using Si.

In a power semiconductor module used for an inverter device, a return current diode is connected in antiparallel to a switching device (semiconductor switching element). At this occasion, in a conventional power semiconductor module, a Si-PiN diode (p-Intrinsic-n Diode) is used as a diode for a return current. This Si-PiN diode is a bipolar semiconductor element (bipolar type diode), and is structured such that a forward voltage drop reduces due to conductivity modulation when a large current is passed with the forward bias.

However, the Si-PiN diode which is the bipolar type diode has such characteristic that, in the process of transition from the forward bias state to the reverse bias state, carriers remaining in the Si-PiN diode are generated as a reverse recovery current (recovery current) due to conductivity modulation. At this occasion, in the Si-PiN diode, the lifespan of the remaining carriers is long, and accordingly, the reverse recovery current is large. For this reason, there are drawbacks in that this reverse recovery current increases the loss that occurs when the power semiconductor switching element is turned ON (hereinafter referred to as turn ON loss Eon) and increases the reverse recovery loss that occurs in the diode when the return current diode is reversely recovered (hereinafter referred to as recovery loss Err).

On the other hand, the Schottky-Barrier diode (hereinafter referred to as SBD) is a unipolar semiconductor element (unipolar type diode), and hardly generates carriers due to conductivity modulation, and therefore, when the SBD is used in an inverter device, the reverse recovery current of a return current diode (recovery current) is extremely small, and therefore, the turn ON loss Eon of the power semiconductor switching element and the recovery loss Err of the return current diode can be reduced.

At this occasion, Si has a low breakdown electric field strength, and therefore, when an SBD of a unipolar type diode in a structure of having a high breakdown voltage is made, a large resistance occurs when it is energized, and therefore, the breakdown voltage of the Si-SBD is as much as about 200 V. On the other hand, SiC has a breakdown electric field strength ten times as large as that of Si, and therefore, when SiC is used, an SiC-SBD having a still higher breakdown voltage than 200 V can be achieved, and by reducing the turn ON loss Eon and the recovery loss Err, the loss of the inverter is reduced, and a highly efficient power semiconductor module can be realized.

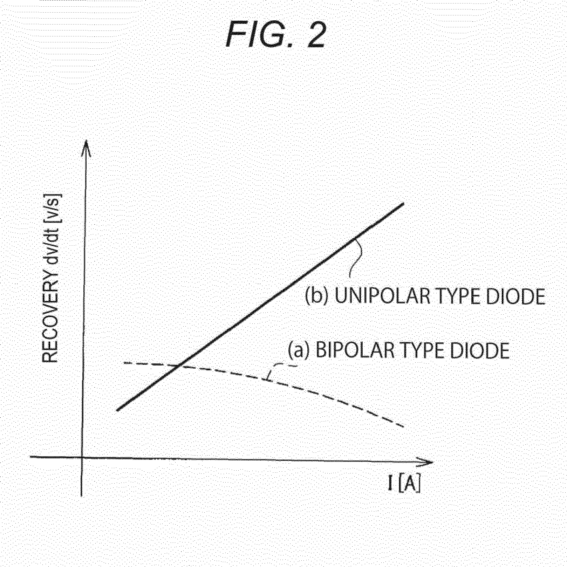

It is known that the recovery loss Err of the return current diode is caused by the rate of change of the voltage during the reverse recovery of the diode, i.e., the magnitude of the recovery dv/dt of the return current diode. Fig. 2 is a characteristic diagram illustrating current dependency of the recovery dv/dt of each of the unipolar type diode and the bipolar type diode, and the horizontal axis denotes a main circuit current (I), and the vertical axis denotes the recovery dv/dt. More specifically, Fig. 2 illustrates the current dependency of the recovery dv/dt of each of a case where SiC-SBD is used as the unipolar type diode and a case where an Si-PiN diode is used as the bipolar type diode.

More specifically, the current dependency of the recovery dv/dt of the return current diode is such that, when the bipolar type diode is used, the current dependency is inversely proportional to the current value as indicated by the characteristic (a) in Fig. 2, and when the unipolar type diode is used, the current dependency is proportional to the current value as indicated by the characteristic (b) in Fig. 2, and it is widely known that the tendency of the change is significant.

For example, Patent Literature 1 and the like disclose a gate drive circuit of an electrical power converter using a bipolar type diode arranged in antiparallel to a power semiconductor switching element on the basis of the above precondition. The gate drive circuit disclosed in this technique uses the bipolar type diode arranged in antiparallel to the power semiconductor switching element, and therefore, in a case where the main circuit current I during the turn ON state is small as indicated by the characteristic (a) of Fig. 2, the recovery dv/dt is large, whereby the gate resistance value of the power semiconductor switching element is increased to reduce the generated noise, and this prevents the power semiconductor switching element and the like from breaking down. When the main circuit current I is large, the recovery dv/dt is small, and accordingly, the gate resistance value is reduced to suppress the turn ON loss.

In this case, the return current diode is connected to the power semiconductor switching element in an antiparallel manner, and therefore, the recovery dv/dt of the diode is in synchronization with dv/dt of the power semiconductor switching element. Therefore, dv/dt of the power semiconductor switching element is suppressed, whereby the recovery dv/dt of the diode can be suppressed. It is known that dv/dt of the power semiconductor switching element is such that, the current value flowing to the gate is limited by increasing the gate resistance value, whereby the rise of the gate voltage can be delayed, and accordingly, dv/dt of the power semiconductor switching element is also suppressed. Therefore, in order to control the recovery dv/dt of the return current diode, it is useful to control the gate resistance value of the power semiconductor switching element in synchronization therewith, i.e., the gate impedance. In Patent Literature 1, by making use of this characteristic, the recovery dv/dt of the bipolar type diode is controlled.

### Citation List

### Patent Literature

PTL 1: JP 11-69779 A

### Summary of Invention

### Technical Problem

More specifically, in the gate drive method according to Patent Literature 1 explained above, the bipolar type diode is used as the return current diode connected in antiparallel to the power semiconductor switching element. In a case where the main circuit current value is small when the power semiconductor switching element is turned ON, the gate resistance value of the power semiconductor switching element is increased and the recovery dv/dt of the bipolar type diode is decreased, whereby oscillation of the main circuit current is suppressed when the power semiconductor switching element is turned ON, thus reduce the generated noise and preventing the element from breaking down. In a case where the main circuit current value when the power semiconductor switching element is turned ON is large, the gate resistance value of the power semiconductor switching element is reduced, whereby the speed of turn-ON process is increased, and the turn ON loss is suppressed. Such control method is effective for the bipolar type diode having the current dependency of the recovery dv/dt as indicated by the characteristic (a) of Fig. 2.

However, the current dependency of the recovery dv/dt of the unipolar type diode such as SiC-SBD, is greatly different from the current dependency of the recovery dv/dt of the bipolar type diode as indicated by the characteristic (b) of Fig. 2. In other words, with the recovery loss Err of the return current diode that can be reduced by using SiC-SBD as the unipolar type diode, the recovery dv/dt of the return current diode which is the cause of this recovery loss Err increases in proportion to the current value as indicated by the characteristic (b) of Fig. 2, and the current dependency is significant as compared with the bipolar type diode. Therefore, when the unipolar type diode is used, it is impossible to perform drive control so as to reduce the gate resistance value during a large current state in the same manner as the case where the bipolar type diode is used. This will be explained hereinafter in more details.

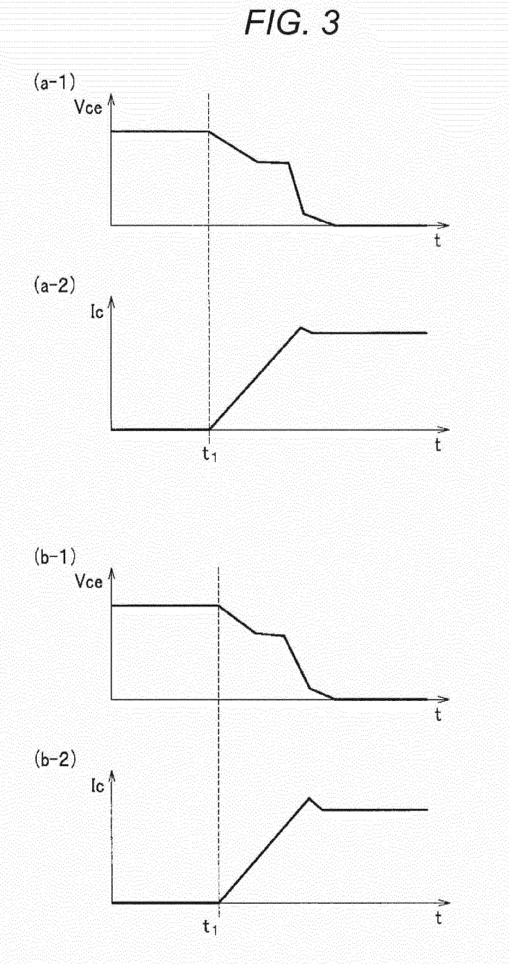

Figs. 3(a-1) to 3(b-2) are operation waveform diagrams illustrating a conventional example when the bipolar type diode is used and a case where Patent Literature 1 is applied. Figs. 3(a-1) and 3 (a-2) illustrate the conventional example, and Figs. 3(b-1) and 3(b-2) illustrate the case where Patent Literature 1 is applied. More specifically, Figs. 3(a-1) to 3(b-2) are operation waveform diagrams when the power semiconductor switching element is turned ON in a case where the bipolar type diode is used when the main circuit current is a large current, and Fig. 3(a-1) indicates an operation waveform of a collector-emitter voltage Vce in a case where the gate resistance value is not changed which is the conventional example, Fig. 3(a-2) indicates an operation waveform of a collector current Ic in a case where the gate resistance value is not changed which is the conventional example, Fig. 3(b-1) indicates an operation waveform of a collector-emitter voltage Vce in a case where the gate resistance value is decreased by applying Patent Literature 1, and Fig. 3(b-2) indicates an operation waveform of a collector current Ic in a case where the gate resistance value is decreased by applying Patent Literature 1. It should be noted that the horizontal axis denotes a time in any of the drawings, and the vertical axes respectively denote the collector-emitter voltage Vce and the collector current Ic of the power semiconductor switching element. The Si-PiN diode is used as the bipolar type diode. The bipolar type diode is connected in antiparallel to the power semiconductor switching element.

More specifically, in a case where a large current which is more than a predetermined value flows in the inverter device using the bipolar type diode in antiparallel to the power semiconductor switching element, dv/dt of the collector-emitter voltage Vce of the power semiconductor switching element is small during a large current state as indicatedby Fig. 3(a-1) (more specifically, the recovery dv/dt of the bipolar type diode is small), and therefore, when Patent Literature 1 is applied to decrease the gate resistance value, dv/dt of the collector-emitter voltage Vce of the power semiconductor switching element as indicated by Fig. 3(b-1) becomes larger (more specifically, the recovery dv/dt of the bipolar type diode becomes larger), and therefore, the turn ON loss can be reduced.

This will be explained in more details. In a case where the gate resistance value of the power semiconductor switching element is large, a time constant based on the gate resistance value and the parasitic capacitance (C) of the power semiconductor switching element is large, and therefore, a rising waveform of the gate signal during the turn On state (time t1) becomes mild, and therefore, as indicated by Fig. 3 (a-1), dv/dt of the collector-emitter voltage Vce of the power semiconductor switching element becomes small. More specifically, the fall of the collector-emitter voltage Vce becomes mild. Accordingly, when the gate resistance value is decreased by applying Patent Literature 1, the time constant based on the gate resistance value and the parasitic capacitance (C) of the power semiconductor switching element becomes small. Therefore, the falling waveform of the gate signal during the turn ON state (time t1) becomes steep, and therefore, as indicated by Fig. 3(b-1), dv/dt of the collector-emitter voltage Vce of the power semiconductor switching element becomes large. More specifically, the fall of the collector-emitter voltage Vce becomes steep. As a result, the turn ON loss of the power semiconductor switching element can be reduced.

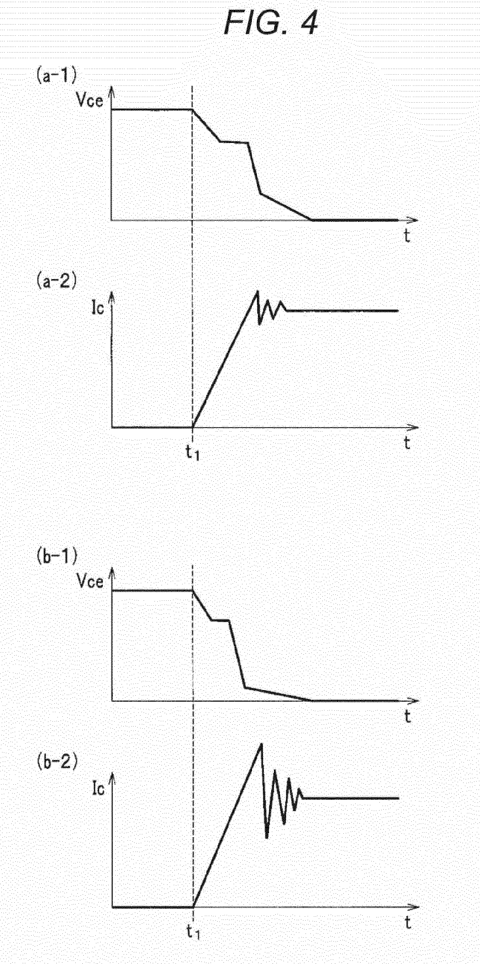

Figs. 4(a-1) to 4(b-2) are operation waveform diagrams illustrating a conventional example when the unipolar type diode is used and a case where Patent Literature 1 is applied. Figs. 4(a-1) and 4(a-2) illustrate the conventional example, and Figs. 4(b-1) and 4(b-2) illustrate the case where Patent Literature 1 is applied. More specifically, Figs. 4(a-1) to 4(b-2) are operation waveform diagrams when the power semiconductor switching element is turned ON in a case where the unipolar type diode is used when the main circuit current is a large current, and Fig. 4(a-1) indicates an operation waveform of a collector-emitter voltage Vce in a case of a predetermined gate resistance value, Fig. 4(a-2) indicates an operation waveform of a collector current Ic in a case of a predetermined gate resistance value, Fig. 4(b-1) indicates an operation waveform of a collector-emitter voltage Vce in a case where the gate resistance value is decreased by applying Patent Literature 1, and Fig. 4(b-2) indicates an operation waveform of a collector current Ic in a case where the gate resistance value is decreased by applying Patent Literature 1. It should be noted that the horizontal axis denotes a time in any of the drawings, and the vertical axes respectively denote the collector-emitter voltage Vce and the collector current Ic of the power semiconductor switching element. An SiC-SBD is used as the unipolar type diode.

More specifically, in a case where a large current flows in the inverter device using the unipolar type diode in antiparallel to the power semiconductor switching element, the recovery dv/dt of the unipolar type diode is large as shown in Fig. 2. In other words, when the unipolar type diode is used, dv/dt of the collector-emitter voltage Vce of the power semiconductor switching element is large when a large current flows as indicated by of Fig. 4(a-1) (falls steeply). Therefore, as indicated by of Fig. 4(a-2), some ripple oscillation (ringing) may occur in the collector current Ic during the turn On state of the power semiconductor switching element.

Therefore, when the unipolar type diode is used, and the gate resistance value is further decreased by applying the gate drive method of Patent Literature 1 when a large current flows, then, as indicated by Fig. 4(b-1), dv/dt of the collector-emitter voltage Vce of the power semiconductor switching element still increases. As a result, as indicated by Fig. 4(b-2), the ringing of the collector current Ic greatly increases.

In other words, as the gate resistance value of the power semiconductor switching element is decreased, the time constant based on the gate resistance value and the parasitic capacitance (C) of the power semiconductor switching element still more decreases, and therefore, the rising waveform of the gate signal at the time t1 during the turn On state becomes still steeper. As a result, dv/dt of the collector-emitter voltage Vce of the power semiconductor switching element becomes large (steep) as indicated by Fig. 4(b-1), and the ringing of the collector current Ic still more greatly increases as indicated by Fig. 4(b-2).

More specifically, the gate drive method of Patent Literature 1 can reduce the turn ON loss by suppressing the oscillation of the collector current due to the recovery dv/dt in the bipolar type diode, but when the gate drive method of Patent Literature 1 is applied to the unipolar type diode, the ripple oscillation (ringing) of the collector current Ic may increase during a large current state. In other words, in a case where the gate drive method of Patent Literature 1 is applied to the unipolar type diode, the gate resistance value is increased when the main circuit current value is small during the turn ON state of the power semiconductor switching element, whereby the turn ON loss still more increases, and the gate resistance value is decreased when the main circuit current is large, whereby the recovery dv/dt which is done faster in proportion to the current value still more increases, and therefore, there is a problem in that the radiation noise from the inverter may increase, and the insulation of a motor which is a load is degraded in a shorter time.

The present invention is made in view of such circumstances, and it is an object of the present invention to an inverter device capable of suppressing ringing of a collector current of a power semiconductor switching element even in a case where a unipolar type diode is employed as a return current diode connected in antiparallel to the power semiconductor switching element.

### Solution to Problem

In order to solve the above problem, an inverter device of the present invention is configured as follows. That is, there is provide the inverter device of the present invention including a power semiconductor module in which a power semiconductor switching element and a unipolar type diode are connected in an antiparallel manner, the inverter device including: current detection means configured to detect a current flowing in the power semiconductor module; and gate impedance switch means configured to switch gate impedance so as to increase the gate impedance of a gate drive circuit for driving the power semiconductor switching element when a current value detected by the current detection means is more than a predetermined value.

### Advantageous Effects of Invention

According to the present invention, an inverter device can be provided that can suppress ringing of a collector current even in a case where a unipolar type diode is employed as a return current diode

### Brief Description of Drawings

[Fig. 1] Fig. 1 is a configuration diagram illustrating an inverter device according to a first embodiment of the present invention.
[Fig. 2] Fig. 2 is a characteristic diagram illustrating a current dependency of a recovery dv/dt of each of a unipolar type diode and a bipolar type diode.
[Figs. 3(a-1) to 3(b-2)] Figs. 3(a-1) to 3(b-2) are operation waveform diagrams illustrating a conventional example when a bipolar type diode is used and a case where Patent Literature 1 is applied, and Figs. 3(a-1) and 3 (a-2) illustrate the conventional example, and Fig. 3(b-1) and 3 (b-2) illustrate the case where Patent Literature 1 is applied.
[Figs. 4(a-1) to 4(b-2)] Figs. 4(a-1) to 4(b-2) are operation waveform diagrams illustrating a conventional example when a unipolar type diode is used and a case where Patent Literature 1 is applied, and Figs. 4(a-1) and 4(a-2) illustrate the first embodiment, and Fig. 4(b-1) and 4(b-2) illustrate the conventional example.
[Figs. 5(a) to 5(d)] Figs. 5(a) to 5(d) are waveform diagrams of units illustrating operation of the inverter device according to the first embodiment of the present invention.
[Figs. 6(a-1) to 6(b-2)] Figs. 6(a-1) to 6(b-2) are operation waveform diagrams illustrating the first embodiment and a conventional example when the unipolar type diode is used, and Figs. 6(a-1) and 6(a-2) illustrate the first embodiment, and Fig. 6(b-1) and 4 (b-2) illustrate the conventional example.
[Fig. 7] Fig. 7 is a configuration diagram illustrating an inverter device according to a second embodiment of the present invention.
[Figs. 8(a) to 8(e)] Figs. 8(a) to 8(e) are waveform diagrams of units illustrating operation of the inverter device according to the second embodiment of the present invention.
[Fig. 9] Fig. 9 is a configuration diagram illustrating an inverter device according to a third embodiment of the present invention.
[Figs. 10 (a) to 10 (f)] Figs. 10 (a) to 10 (f) are waveform diagrams of units illustrating operation of the inverter device according to the third embodiment of the present invention.

### Description of Embodiments

### «Overview»

An inverter device according to an embodiment of the present invention is an inverter device including a power semiconductor module in which a power semiconductor switching element and a unipolar type diode of a wide gap semiconductor such as SiC and GaN are connected in an antiparallel manner, wherein when a main circuit current of the inverter device is more than a predetermined value, a gate resistance value (gate impedance) for switching and driving the power semiconductor switching element is increased. Accordingly, the recovery dv/dt of the unipolar type diode is decreased, and the turn ON loss of the power semiconductor switching element and the recovery loss of the unipolar type diode can be decreased, and the ripple (ringing) due to oscillation of the collector current of the power semiconductor switching element can be suppressed.

The inverter device according to the embodiment of the present invention is configured such that in a case where the main circuit current of the inverter device that performs PWM (Pulse Width Modulation) control is more than a predetermined value, the gate resistance value (gate impedance) for switching and driving the power semiconductor switching element is increased, and the number of pulses of the PWM signal for driving the inverter device is decreased. Therefore, the turn ON loss, the recovery loss, and the ringing can be suppressed, and the switching loss of the power semiconductor switching element can be decreased.

Several embodiments of an inverter device according to the present invention will be explained in detail with reference to drawings. In all the drawings for explaining the embodiments, the same constituent elements are basically denoted with the same reference numerals, and repeated explanation thereabout is omitted.

### <<First embodiment>>

### <Configuration of inverter device>

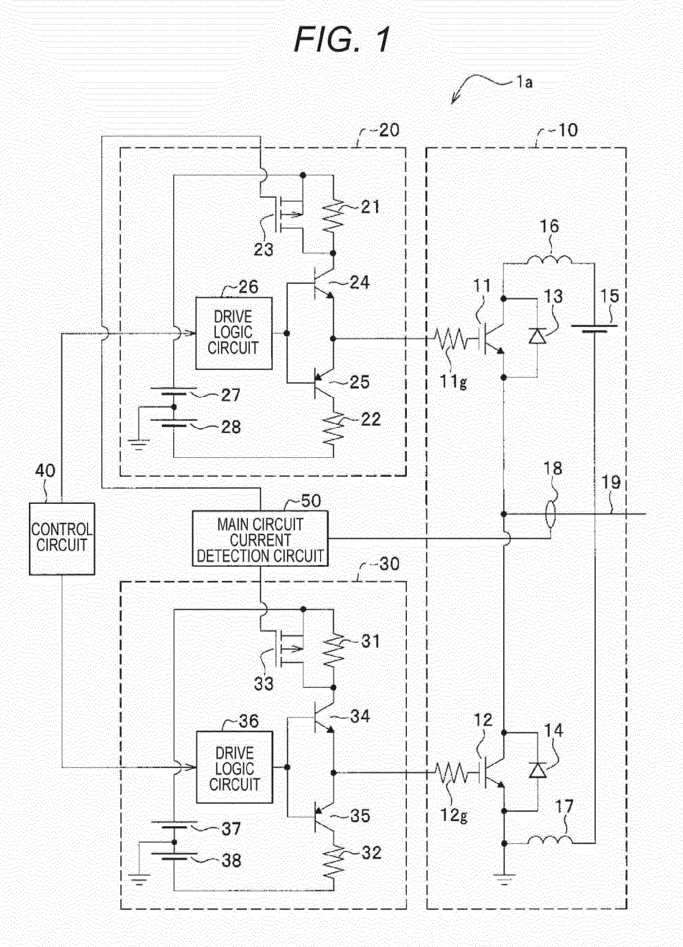

Fig. 1 is a configuration diagram illustrating an inverter device according to the first embodiment of the present invention. In general, an inverter device is constituted by a full-bridge circuit, but for the sake of explanation of the present embodiment, Fig. 1 illustrates an inverter device of a half bridge circuit.

First, a configuration of an inverter device according to the first embodiment of the present invention will be explained. As shown in Fig. 1, an inverter device 1a includes an inverter main circuit 10, an upper arm drive/control circuit 20, a lower arm drive/control circuit 30, a control circuit 40, and a main circuit current detection circuit 50.

The inverter main circuit 10 includes Si-IGBTs (Silicon Insulated Gate Bipolar Transistors) 11, 12 which are two power semiconductor switching elements connected in series, gate resistors 11g, 12g, unipolar type diodes 13, 14 connected in antiparallel to the Si-IGBTs 11, 12, respectively, a main circuit power supply 15, a main circuit inductors 16, 17, a main circuit current detection current transformer (CT) 18, and a main circuit 19.

The Si-IGBTs 11, 12 are power semiconductor switching elements for switching the conductive state and non-conductive state between the collector terminal and the emitter terminal in accordance with a signal which is input into the gate terminal. The Si-IGBT 11 and the unipolar type diode 13, and the Si-IGBT 12 and the unipolar type diode 14 each constitute a power semiconductor module. The main circuit power supply 15 is a direct current power supply for applying a direct current voltage between the positive terminal and the negative terminal. Further, the main circuit current detection current transformer (CT) 18 is current detection means for outputting a signal according to a current flowing into the main circuit 19.

One of the terminals of the main circuit inductor 16 is connected to the positive terminal of the main circuit power supply 15. The other of the terminals of the main circuit inductor 16 is connected to the collector terminal of the Si-IGBT 11 connected in series. One of the terminals of the main circuit inductor 17 is connected to the negative terminal of the main circuit power supply 15. The other of the terminals of the main circuit inductor 17 is connected to the emitter terminal of the Si-IGBT 12 connected in series and is also connected to the ground. A node where the emitter terminal of the Si-IGBT 11 and the collector terminal of the Si-IGBT 12 are connected is connected via the main circuit current detection current transformer (CT) 18 and the main circuit 19 to a load, not shown.

The gate terminal of the Si-IGBT 11 of the upper arm is connected via the gate resistor 11g to the upper arm drive/control circuit 20 for driving the Si-IGBT 11 of the upper arm. Likewise, the gate terminal of the Si-IGBT 12 of the lower arm is connected via the gate resistor 12g to the lower arm drive/control circuit 30 for driving the Si-IGBT 12 of the lower arm.

The lower arm drive/control circuit 30 includes gate resistors 31, 32, a gate resistance switching pMOS (positive channel Metal Oxide Semiconductor) 33, an npn transistor 34, a pnp transistor 35, a drive logic circuit 36, and lower arm drive/control circuit power supplies 37, 38. It should be noted that the npn transistor 34 and the pnp transistor 35 may be replaced with pMOS, nMOS (negative channel Metal Oxide Semiconductor), and the like.

The circuit configuration of the lower arm drive/control circuit 30 is as follows. More specifically, the gate resistance switching pMOS 33 and the gate resistor 31 are connected in parallel. The source side of the gate resistance switching pMOS 33 is connected to the positive terminal of the lower arm drive/control circuit power supply 37. The drain side of the gate resistance switching pMOS 33 is connected to the collector terminal of the npn transistor 34. The emitter terminal of the npn transistor 34 is connected to the emitter terminal of the pnp transistor 35, and is connected to one of the terminals of the gate resistor 11g of the inverter main circuit 10. The collector terminal of the pnp transistor 35 is connected to one end of the gate resistor 32, and the other end of the gate resistor 32 is connected to the negative terminal of the lower arm drive/control circuit power supply 38. The positive terminal of the lower arm drive/control circuit power supply 38 is connected to the negative terminal of the lower arm drive/control circuit power supply 37, and is connected to the ground. In the control signal system, the gate terminal of the gate resistance switching pMOS 33 is connected to the main circuit current detection circuit 50, and the base terminals of the npn transistor 34 and the pnp transistor 35 are connected to one end of the drive logic circuit 36, and the other end of the drive logic circuit 36 is connected to the control circuit 40.

In the circuit configuration explained above, the drive logic circuit 36 receives a drive signal (for example, PWM signal) from the control circuit 40, and alternately performs switching operation of the npn transistor 34 and the pnp transistor 35. The npn transistor 34 and the pnp transistor 35 amplify the drive signal (for example, PWM signal) of the drive logic circuit 36, and perform switching drive (for example, PWM driving) of the Si-IGBT 12 of the lower arm.

The upper arm drive/control circuit 20 also has the same configuration which includes gate resistors 21, 22, a gate resistance switching pMOS 23, an npn transistor 24, a pnp transistor 25, a drive logic circuit 26, and upper arm drive/control circuit power supplies 27, 28. The circuit configuration of the upper arm drive/control circuit 20 is the same as the circuit configuration of the lower arm drive/control circuit 30, and therefore, repeated explanation thereabout is omitted.

The detection terminal of the main circuit current detection circuit 50 is connected to the main circuit current detection current transformer (CT) 18, and the control terminal of the upper arm of the main circuit current detection circuit 50 is connected to the gate terminal of the gate resistance switching pMOS 23 of the upper arm drive/control circuit 20, and the control terminal of the lower arm is connected to the gate terminal of the gate resistance switching pMOS 33 of the lower arm drive/control circuit 30. The main circuit current detection circuit 50 receives the main circuit current detection signal from the main circuit current detection current transformer (CT) 18 of the inverter main circuit 10, and performs the ON/OFF control on the gate resistance switching pMOS 23 of the upper arm drive/control circuit 20 and the gate resistance switching pMOS 33 of the lower arm drive/control circuit 30.

The control circuit 40 has the control signal lines connected to the drive logic circuit 26 of the upper arm drive/control circuit 20 and the drive logic circuit 36 of the lower arm drive/control circuit 30. Therefore, the control circuit 40 controls the drive logic circuit 26 of the upper arm drive/control circuit 20 thus being able to drive and control the npn transistor 24 and the pnp transistor 25, and controls the drive logic circuit 36 of the lower arm drive/control circuit 30 thus being able to drive and control the npn transistor 34 and the pnp transistor 35. Accordingly, each of the Si-IGBT 11 of the upper arm and the Si-IGBT 12 of the lower arm can perform switching operation of the PWM control in response to the PWM signal generated by the control circuit 40. Alternatively, the control circuit 40 may cause the Si-IGBT 11 of the upper arm and the Si-IGBT 12 of the lower arm to perform switching operation so as to be energized alternately 180 degrees from each other.

In the first embodiment of the present invention, in a case where a return current diode having such characteristic that a recovery dv/dt is proportional to a current value such as a unipolar type diode is used as a power semiconductor module connected in antiparallel to the power semiconductor switching element, the upper arm drive/control circuit 20 and the lower arm drive/control circuit 30 connects and shorts the gate resistor 21 and the gate resistor 22, respectively, in accordance with the main circuit current detected by the main circuit current detection circuit 50, and are configured to switch and control the gate resistance values (gate impedances) of the Si-IGBT 11 and the Si-IGBT 12. In this case, the gate resistance is a resistance provided between the gate terminal and the gate power supply so as to stably perform the switching operation of the Si-IGBT 11 of the upper arm and the Si-IGBT 12 of the lower arm.

### <Operation of inverter device according to first embodiment)

The basic operation of the inverter device 1a as shown in Fig. 1 will be hereinafter explained. In response to the control signals of the control circuit 40, the drive logic circuit 26 of the upper arm drive/control circuit 20 and the drive logic circuit 36 of the lower arm drive/control circuit 30 are controlled, and the Si-IGBT 11 and the Si-IGBT 12 which are power semiconductor switching elements are caused to alternately perform ON/OFF operation, whereby the direct current voltage of the main circuit power supply 15 is converted into an alternate current voltage, and the alternate current (main circuit current) flows into the main circuit 19 and is provided to a load (not shown), and the main circuit current flowing into the main circuit 19 is detected by the main circuit current detection current transformer (CT) 18, and is provided to the main circuit current detection circuit 50. It should be noted that the control circuit 40 may perform PWM control of the Si-IGBT 11 and the Si-IGBT 12, or may perform rectangular wave control by turning ON/OFF the Si-IGBT 11 and the Si-IGBT 12 with an electrical angle of 180 degrees. Alternatively, the control circuit 40 may perform duty width control (phase control) for controlling the energizing angle on the basis of the rectangular wave control.

Now, overview of the ON/OFF operation of the Si-IGBT 11 and the Si-IGBT 12 will be explained. When the Si-IGBT 11 turns ON, the Si-IGBT 12 turns OFF, but the unipolar type diode 14 which is the return current diode connected in antiparallel to the Si-IGBT 12 turns ON to pass the return current. Likewise, when the Si-IGBT 12 turns ON, the Si-IGBT 11 turns OFF, but the unipolar type diode 13 which is the return current diode connected in antiparallel to the Si-IGBT 11 turns ON to pass the return current. In the process of such switching operation, when the Si-IGBTs 11, 12 turn ON, reverse recovery voltage (recovery voltage) is generated in each of the unipolar type diodes 13, 14.

The upper arm drive/control circuit 20 and the lower arm drive/control circuit 30 have the same configuration and perform the same operation, and therefore, the transition of change of the collector-emitter voltage during the turn ON state of the Si-IGBTs 11, 12 according to the present embodiment (i.e., transition of change of the recovery voltage of the unipolar type diodes 13, 14) will be explained using the lower arm drive/control circuit 30 for the sake of convenience. Therefore, the explanation about the operation of the upper arm drive/control circuit 20 is omitted in order to avoid redundancy.

More specifically, in the present embodiment, in a case where a return current diode having such characteristic that a recovery dv/dt is proportional to a current value such as a unipolar type diode is used, the upper arm drive/control circuit 20 and the lower arm drive/control circuit 30 perform control to switch the gate resistance values of the Si-IGBT 11 and the Si-IGBT 12 on the basis of the main circuit current detected by the main circuit current detection current transformer 18, and in the present embodiment, this operation will be explained using the lower arm drive/control circuit 30.

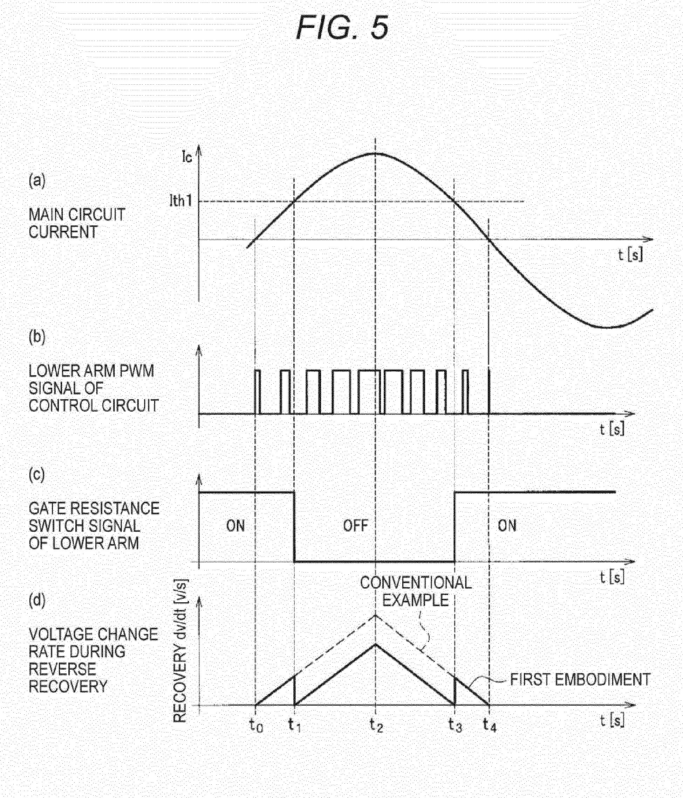

Figs. 5(a) to 5(d) are waveform diagrams of units illustrating operation of the inverter device according to the first embodiment of the present invention. Fig. 5(a) shows the main circuit current. Fig. 5(b) shows a lower arm PWM signal of the control circuit. Fig. 5(c) shows a gate resistance switch signal of the lower arm which the main circuit current detection circuit 50 transmits to the gate terminal of the gate resistance switching pMOS 33 in accordance with whether the main circuit current is more than a predetermined threshold value or not. Fig. 5(d) illustrates a voltage change rate (recovery dv/dt) during reverse recovery of the unipolar type diode 14 of the lower arm. In any of the drawings, the horizontal axis represents a time, and the vertical axis represents the level of each of them. The main circuit current (a) is represented in such a manner that the direction of the current (collector current Ic) flowing from a load not shown in Fig. 1 via the main circuit 19 and flowing from the collector to the emitter of the Si-IGBT 12 is denoted as the positive terminal. The lower arm PWM signal (b) of the control circuit is a signal provided via the drive logic circuit 36 to the gate portion of the Si-IGBT 12 of the lower arm in order to generate the main circuit current (a).

In this case, the relationship between the main circuit current (a) and the voltage change rate (d) during reverse recovery (i.e., recovery dv/dt) of Fig. 5 will be explained. The main circuit current (a) (i.e., collector current Ic) flows in a sine wave manner from the collector to the emitter of the Si-IGBT 12 with, for example, a half cycle of 10 msec. At this occasion, the Si-IGBT 12 performs switching and driving with a carrier frequency of, for example, 100 µsec. The signal of the switching drive at this occasion may be a carrier frequency based on the PWM signal for duty ratio control, or may be a carrier frequency of an ON/OFF signal of which duty ratio is 50% without performing the duty ratio control. In any case, the Si-IGBT 12 performs switching and driving with a carrier frequency of 100 µsec. More specifically, in the half cycle of 10 msec of the main circuit current (collector current Ic), the Si-IGBT 12 performs switching and driving 100 times. Therefore, every time the Si-IGBT 12 performs the switching and driving, dv/dt occurs in the collector voltage of the Si-IGBT 12. (i.e., the recovery dv/dt occurs in the unipolar type diode 14.) The voltage change rate (d) during the reverse recovery of each cycle generated with the carrier frequency at this occasion (i.e., recovery dv/dt) increases as the main circuit current (a) (i.e., collector current Ic) increases. For this reason, the main circuit current (a) (i.e., collector current Ic) increases to a predetermined current value, the gate resistance value of the Si-IGBT 12 is increased, thus reducing the voltage change rate (d) during the reverse recovery on every cycle of the carrier frequency (i.e., recovery dv/dt). The details of this will be hereinafter explained.

In this case, the control circuit 40 performs the PWM control as shown in Fig. 5 (b), so that the main circuit current is made into the sine wave as shown in Fig. 5(a). However, the present embodiment is not limited thereto. The control circuit 40 may perform 180 degrees energizing control with a carrier frequency of ON/OFF, and alternately turn ON/OFF the Si-IGBT 11 and the Si-IGBT 12 with the carrier frequency to output a rectangular wave, and an output side filter of the inverter device 1a (not shown in Fig. 1) may remove harmonics, so that the output current (main circuit current) may be made into a sine wave form as indicated by Fig. 5(a).

Subsequently, operation of the inverter according to the first embodiment of the present invention will be explained with reference to Figs. 1 and 5. When the main circuit current (a) of the sine wave starts to increase from zero at a time t0, the voltage change rate (d) during reverse recovery of the unipolar type diode 14 also increases. At this occasion, in a case where the main circuit current detected by the main circuit current detection current transformer 18 is less than a predetermined value, the main circuit current detection circuit 50 transmits the ON signal to the control terminal of the gate resistance switching pMOS 33. More specifically, the gate resistance switch signal (c) of the lower arm is ON. Accordingly, the gate resistance value of the Si-IGBT 12 of the lower arm is the resistance value of only the gate resistance 12g because the gate resistance switching pMOS 33 is in the ON state.

Then, at a time t1, when the main circuit current (a) detected by the main circuit current detection current transformer 18 is more than a predetermined threshold value Ith1 (for example, 1/2 of the peak value of the main circuit current), the main circuit current detection circuit 50 transmits the OFF signal to the control terminal of the gate resistance switching pMOS 33. More specifically, the gate resistance switch signal (c) of the lower arm changes from ON to OFF. Therefore, the gate resistance value of the Si-IGBT 12 of the lower arm is a summation of the resistance value of the gate resistance 12g and the resistance value of the gate resistor 31 because the gate resistance switching pMOS 33 is in the OFF state. Accordingly, the current change rate (di/dt) decreases when the Si-IGBT 12 is in the turn ON state, and the voltage change rate (d) during the reverse recovery of the unipolar type diode 14 connected in an antiparallel manner, i.e., the recovery dv/dt decreases from the level indicated by a broken line (the level of the conventional example in Fig. 5(d)) to the level indicated by a solid line (the level of the first embodiment in Fig. 5(d) after the time t1. As a result, the surge voltage of the collector-emitter voltage Vce of the Si-IGBT 11 (ringing voltage) can be reduced.

Then, from the time t1 to the time t2, in accordance with the increase of the main circuit current (a), the voltage change rate (d) during the reverse recovery of the unipolar type diode 14, i.e., the recovery dv/dt increases, but the gate resistance value of the Si-IGBT 12 is the summation of the resistance value of the gate resistance 12g and the resistance value of the gate resistor 31, and therefore, the recovery dv/dt of the unipolar type diode 14 changes at a level lower than that of the conventional example.

Subsequently, after the time t2, in accordance with the decrease of the main circuit current (a), the voltage change rate (d) during the reverse recovery of the unipolar type diode 14, i.e., the recovery dv/dt, decreases. Then, at the time t3, when the main circuit current (a) detected by the main circuit current detection current transformer 18 decreases to a predetermined threshold value Ith1 (for example, 1/2 of the peak value of the main circuit current), the main circuit current detection circuit 50 transmits the ON signal to the control terminal of the gate resistance switching pMOS 33. More specifically, the gate resistance switch signal (c) of the lower arm changes from OFF to ON.

Therefore, the gate resistance value of the Si-IGBT 12 of the lower arm is only the resistance value of the gate resistance 12g because the gate resistance switching pMOS 33 is in the ON state. As a result, after the time t3, the recovery dv/dt increases to the same level as that of the conventional example, but at this occasion, the main circuit current (a) decreases to a level less than the predetermined threshold value Ith1, and accordingly the value of the recovery dv/dt is also low. Then, at the time t4, when the main circuit current (a) becomes zero, the value of the recovery dv/dt becomes also zero.

It should be noted that the main circuit current detection circuit 50 is not limited to the main circuit current detection current transformer 18. The main circuit current can be easily detected by using a circuit using a shunt resistor and an IGBT having a sensing function. The portion where the main circuit current is detected is not limited to the position of the main circuit 19 as shown in Fig. 1. The main circuit current may also be detected at positions such as the emitter of the Si-IGBT 12, the collector of the Si-IGBT 12, the unipolar type diode 14, or the unipolar type diode 13 at the upper arm side. The reason why the main circuit current can be detected by the unipolar type diode 13 at the upper arm side is because, the main circuit current that passes a load, not shown, when the Si-IGBT 12 of the lower arm is in the ON state returns back to the unipolar type diode 13 of the upper arm. More specifically, the position where the main circuit current is detected may be any position as long as it is a position where the current that flows in the power semiconductor module including the Si-IGBT 12 of the lower arm and the unipolar type diode 14 connected in an antiparallel manner can be detected.

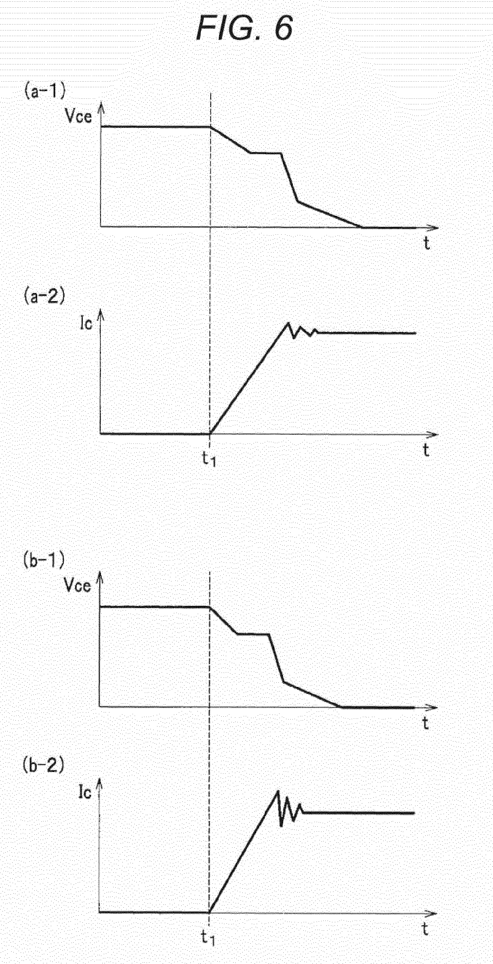

Figs. 6(a-1) to 6(b-2) are operation waveform diagrams illustrating the first embodiment and the conventional example when the unipolar type diode is used. Figs. 6(a-1) and 6(a-2) show the first embodiment. Figs. 6(b-1) and 6(b-2) show the conventional example. More specifically, Figs. 6(a-1) to 6 (b-2) are operation waveform diagrams illustrating during the turn ON state of the power semiconductor switching element in a case where the unipolar type diode is used when the main circuit current is a large current. Fig. 6(a-1) shows the operation waveform of the collector-emitter voltage Vce according to the first embodiment. Fig. 6(a-2) shows the operation waveform of the collector current Ic according to the first embodiment. Fig. 6(b-1) shows the operation waveform of the collector-emitter voltage Vce according to the conventional example. Fig. 6(b-2) shows the operation waveform of the collector current Ic according to the conventional example. In any of the drawings, the horizontal axis represents a time, and the vertical axis represents the collector-emitter voltage Vce or the collector current Ic of the power semiconductor switching element (the Si-IGBT 12 of the lower arm). The SiC-SBD is used as the unipolar type diode.

As shown in Figs. 6(b-1) and 6(b-2), in the conventional example, the gate resistance value of the power semiconductor switching element is fixed, and therefore, when the main circuit current is a large current, the collector-emitter voltage Vce of the power semiconductor switching element (i. e. , the recovery dv/dt of the unipolar type diode) increases, and somewhat large ripple oscillation (ringing) occurs in the collector current Ic of the power semiconductor switching element.

However, in the case of the first embodiment, when the main circuit current is a large current, the gate resistance value of the power semiconductor switching element (i.e., Si-IGBT 12) is increased (the gate resistance value of the power semiconductor switching element is caused to be the summation of the resistance value of the gate resistor 31 and the resistance value of the gate resistance 12g), and therefore, as shown in Figs. 6(a-1) and 6(a-2), the ripple oscillation (ringing) of the collector current Ic of the power semiconductor switching element (Si-IGBT 12) is smaller as compared with the conventional example in which the gate resistance value of the Si-IGBT 12 is constant. In this manner, the gate resistance value is changed to two levels in accordance with the magnitude of the main circuit current, so that the recovery dv/dt of the unipolar type diode can be reduced when the main circuit current is a large current, and therefore, the radiation noise generated by the inverter device 1a is reduced by suppressing the ringing of the collector current Ic, and the lifespan of the insulation resistance of a motor which is a load can be increased.

In other words, when the main circuit current is a large current, the gate resistance value of the power semiconductor switching element is increased, so that the time constant based on the gate resistance value and the parasitic capacitance (C) of the power semiconductor switching element increases, and therefore, the rising waveform of the gate signal becomes mild when the power semiconductor switching element is turned ON. As a result, dv/dt of the collector-emitter voltage Vce of the power semiconductor switching element becomes small (i.e., the recovery dv/dt of the unipolar type diode becomes small), so that the ringing of the collector current Ic can be reduced as shown in Fig. 6(a-2).

### «Second embodiment»

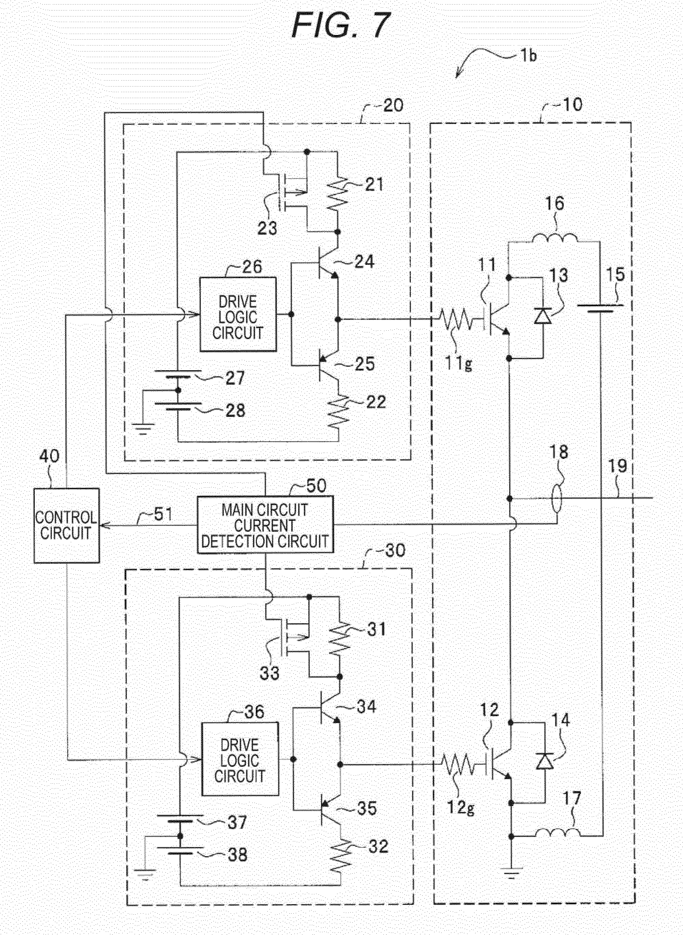

Fig. 7 is a configuration diagram illustrating an inverter device according to the second embodiment of the present invention. An inverter device 1b according to the second embodiment as shown in Fig. 7 has the same reference numerals denoting the same constituent elements as those of the inverter device 1a according to the first embodiment as shown in Fig. 1. The inverter device 1b according to the second embodiment is different from the inverter device 1a according to the first embodiment in that a control signal line 51 is connected from a main circuit current detection circuit 50 to a control circuit 40.

More specifically, in the inverter device 1a according to the first embodiment, the main circuit current detection circuit 50 changes the gate resistance value of the power semiconductor switching element (i.e., Si-IGBTs 11, 12) on the basis of the magnitude of the main circuit current detected by the main circuit current detection current transformer 18, thus suppressing dv/dt of the collector-emitter voltage Vce of the power semiconductor switching element (i.e., the recovery dv/dt of the unipolar type diode). In addition to this, the inverter device 1b according to the second embodiment is configured such that the control signal is transmitted by the control signal line 51 from the main circuit current detection circuit 50 to the control circuit 40, and the number of times the PWM signal is switched is controlled on the basis of the magnitude of the main circuit current detected by the main circuit current detection current transformer 18. Therefore, the ripple oscillation of the collector current Ic of the power semiconductor switching element is suppressed, and the reduction of the efficiency due to the switching loss of the PWM signal can be suppressed.

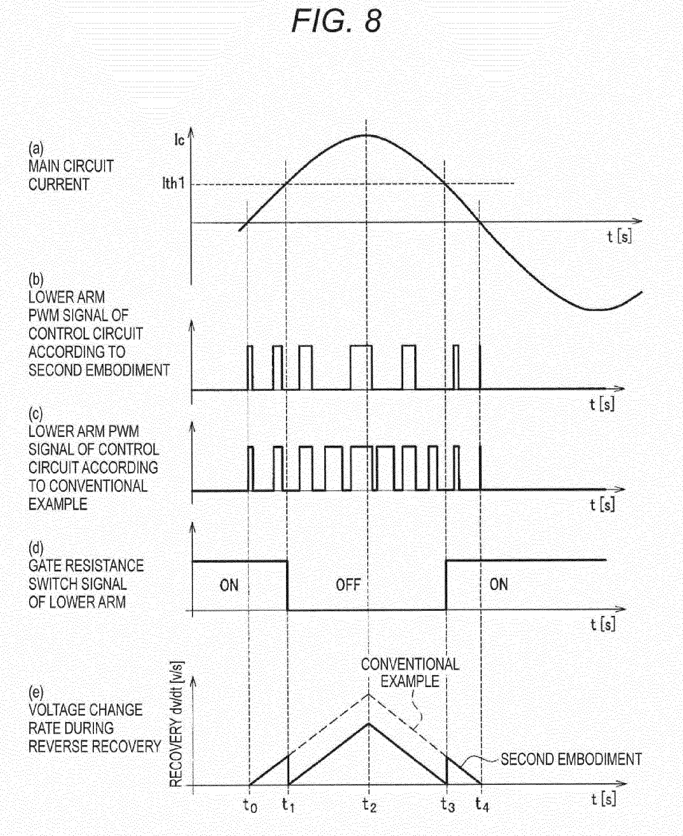

Figs. 8(a) to 8(e) are waveform diagrams of units illustrating operation of the inverter device according to the second embodiment of the present invention. Fig. 8(a) shows the main circuit current Ic. Fig. 8(b) shows a lower arm PWM signal of the control circuit according to the second embodiment. Fig. 8(c) shows a lower arm PWM signal of the control circuit according to the conventional example. Fig. 8(d) shows a gate resistance switch signal of the lower arm which the main circuit current detection circuit 50 transmits to the gate terminal of the gate resistance switching pMOS 33 in accordance with whether the main circuit current is more than a predetermined threshold value or not. Fig. 8(e) illustrates a voltage change rate (recovery dv/dt) during reverse recovery of the unipolar type diode 14 of the lower arm. In any of the drawings, the horizontal axis represents a time, and the vertical axis represents the level of each of them. The main circuit current (a) is represented in such a manner that the direction of the current (collector current Ic) flowing from a load not shown via the main circuit 19 and flowing from the collector to the emitter of the Si-IGBT 12 is denoted as the positive terminal. Further, the lower arm PWM signal (b) of the control circuit according to the second embodiment and the lower arm PWM signal (c) of the control circuit according to the conventional example are signals provided via the drive logic circuit 36 to the gate portion of the Si-IGBT 12 of the lower arm in order to generate the main circuit current (a).

When the main circuit current (a) of the sine wave starts to increase from zero at a time t0 in Fig. 8, the voltage change rate (e) of the output voltage of the unipolar type diode 14 also increases. At this occasion, in a case where the main circuit current detected by the main circuit current detection current transformer 18 is less than a predetermined threshold value Ith1 (for example, 1/2 of the peak value of the main circuit current), the main circuit current detection circuit 50 transmits the ON signal to the control terminal of the gate resistance switching pMOS 33. More specifically, the lower arm gate resistance switch signal (d) is in the ON state. Accordingly, the gate resistance value of the Si-IGBT 12 of the lower arm is the resistance value of only the gate resistance 12g because the gate resistance switching pMOS 33 is in the ON state.

Then, at a time t1, when the main circuit current (a) detected by the main circuit current detection current transformer 18 is more than a predetermined threshold value Ith1, the main circuit current detection circuit 50 transmits the OFF signal to the control terminal of the gate resistance switching pMOS 33. More specifically, the gate resistance switch signal (d) of the lower arm changes to the OFF state. Therefore, the gate resistance value of the Si-IGBT 12 of the lower arm is a summation of the resistance value of the gate resistance 12g and the resistance value of the gate resistor 31 because the gate resistance switching pMOS 33 is in the OFF state. Accordingly, the current change rate (di/dt) decreases when the Si-IGBT 12 is in the turn ON state, and the voltage change rate (e) during the reverse recovery of the unipolar type diode 14 connected in an antiparallel manner, i.e., the recovery dv/dt decreases from the level indicated by a broken line in Fig. 8(e) (the level of the conventional example) to the level indicated by a solid line (the level of the second embodiment) after the time t1. As a result, the ringing of the collector current Ic of the Si-IGBT 12 can be reduced.

Then, from the time t1 to the time t2, in accordance with the increase of the main circuit current (a), the voltage change rate (e) during the reverse recovery, i.e., the recovery dv/dt, increases, but the gate resistance value of the Si-IGBT 12 is the summation of the resistance value of the gate resistance 12g and the resistance value of the gate resistor 31, and therefore, the recovery dv/dt of the unipolar type diode 14 changes at a level lower than that of the conventional example.

Subsequently, after the time t2, in accordance with the decrease of the main circuit current (a), the voltage change rate (e) during the reverse recovery of the unipolar type diode 14, i.e., the recovery dv/dt, decreases. Then, at the time t3, when the main circuit current (a) detected by the main circuit current detection current transformer 18 decreases to a predetermined threshold value Ith1 (for example, 1/2 of the peak value of the main circuit current), the main circuit current detection circuit 50 transmits the ON signal to the control terminal of the gate resistance switching pMOS 33. More specifically, the gate resistance switch signal (d) of the lower arm changes to the ON state.

Therefore, the gate resistance value of the Si-IGBT 12 of the lower arm is only the resistance value of the gate resistance 12g because the gate resistance switching pMOS 33 is in the ON state. As a result, after the time t3, the recovery dv/dt increases to the same level as that of the conventional example, but at this occasion, the main circuit current (a) decreases to a level less than the predetermined value, and accordingly the value of the recovery dv/dt is also low. Then, at the time t4, when the main circuit current (a) becomes zero, the value of the recovery dv/dt becomes also zero.

Further, in the present embodiment, the main circuit current detection circuit 50 transmits information about the main circuit current detected by the main circuit current detection current transformer 18 to the control circuit 40. Accordingly, in a case where the detection value of the main circuit current is large, the control circuit 40 decreases the number of output pulses of the PWM signal that are output to the drive logic circuit 36.

More specifically, as shown in Figs. 8(a) to 8(e), in the electrical angle of 180 degrees in which the power semiconductor switching element (Si-IGBT 12) is driven, the Si-IGBT 12 usually performs the switching control on the basis of the PWM signal without thinning-out as indicated by the lower arm PWM signal (c) of the control circuit according to the conventional example, so that the main circuit current (a) is in the state of the sine wave. However, when each power semiconductor switching element is driven with the PWM signal without thinning-out, the number of times the switching is performed is increased, and this increases the switching loss of the power semiconductor switching element (Si-IGBT 12).

Therefore, between the time t1 and the time t3 in Fig. 8(a) to 8(e), the main circuit current (a) is more than the predetermined threshold value Ith1. During this period, the control circuit 40 thins out the PWM signal to decrease the number of output pulses as indicated by the lower arm PWM signal (b) of the control circuit according to the second embodiment. Accordingly, when the main circuit current (a) is a large current, the number of times the power semiconductor switching element (Si-IGBT 12) is switched is decreased, so that the switching loss of the power semiconductor switching element (Si-IGBT 12) can be decreased. As a result, the reduction of the efficiency of the inverter device 1b can be alleviated.

As described above, in normal circumstances, in a case where the main circuit current is large, and the gate resistance value is increased, then the switching loss of the power semiconductor switching element (Si-IGBT 12) increases, but when the main circuit current is large, the switching loss of the power semiconductor switching element (Si-IGBT 12) can be decreased by decreasing the number of output pulses of the PWM signal which are output from the control circuit 40 to the drive logic circuit 36. For this reason, the inverter device 1b to which the present embodiment is applied can realize a long life span of the insulation resistance of a motor, which is a load, by reducing the radiation noise generated by the inverter device 1b, and can also reduce the electric power loss of the inverter device 1b.

It should be noted that when the PWM signal is greatly thinned out, the switching loss of the power semiconductor switching element can be reduced and the efficiency can be improved, but on the other hand, there is tradeoff such that, when the PWM signal is greatly thinned out, the main circuit current is distorted and it is impossible to maintain a sine wave. Therefore, it is desired to appropriately reduce the number of times of switching of the PWM signal so as to achieve the optimum tradeoff by means of cut-and-try using actual equipment.

### «Third embodiment»

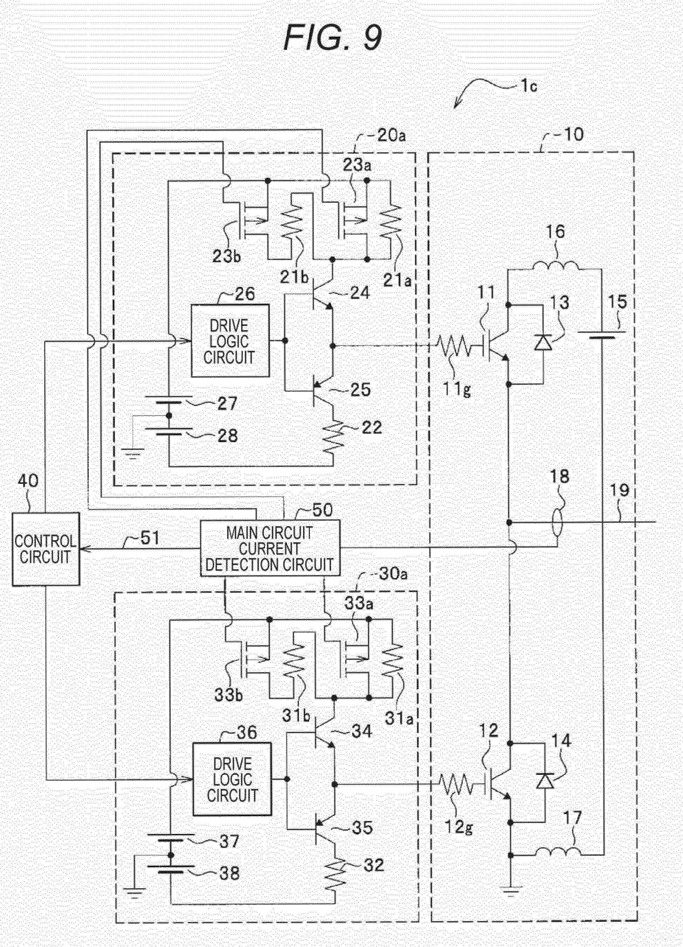

Fig. 9 is a configuration diagram illustrating an inverter device according to the third embodiment of the present invention. An inverter device 1c according to the third embodiment as shown in Fig. 9 has the same reference numerals denoting the same constituent elements as those of the inverter device 1b according to the second embodiment as shown in Fig. 7. The inverter device 1c according to the third embodiment is different from the inverter device 1b according to the second embodiment in that the gate resistance value (gate impedance) of the power semiconductor switching element is switched to three levels.

First, the configuration of the inverter device 1c according to the third embodiment as illustrated in Fig. 9 will be explained without repeated explanation. As shown in Fig. 9, the inverter device 1c the according to the third embodiment of the present invention includes an inverter main circuit 10, an upper arm drive/control circuit 20a, a lower arm drive/control circuit 30a, a control circuit 40, and a main circuit current detection circuit 50. It should be noted that the inverter main circuit 10 and the control circuit 40 are the same as those of Fig. 1 and therefore, explanation about the configuration thereof is omitted.

The circuit configuration of the lower arm drive/control circuit 30a is as follows. More specifically, the positive terminal of the lower arm drive/control circuit power supply 37 is connected to the source terminal of the gate resistance switching pMOS 33a and the source terminal of the gate resistance switching pMOS 33b. The source terminal of the gate resistance switching pMOS 33a is connected to one end of the gate resistor 31a. The drain terminal of the gate resistance switching pMOS 33a is connected to the other end of the gate resistor 31a (more specifically, the gate resistance switching pMOS 33a and the gate resistor 31a are connected in parallel) . Further, the drain terminal of the gate resistance switching pMOS 33a is connected to the collector terminal of the npn transistor 34. The drain terminal of the gate resistance switching pMOS 33b is connected to one end of the gate resistor 31b, and the other end of the gate resistor 31b is connected to the collector terminal of the npn transistor 34.

The emitter terminal of the npn transistor 34 is connected to the emitter terminal of the pnp transistor 35, and is also connected to one of the terminals of the gate resistance 12g of the inverter main circuit 10. Further, the collector terminal of the pnp transistor 35 is connected to one end of the gate resistor 32, and the other end of the gate resistor 32 is connected to the negative terminal of the lower arm drive/control circuit power supply 38. The positive terminal of the lower arm drive/control circuit power supply 38 is connected to the negative terminal of the lower arm drive/control circuit power supply 37 and is also connected to the ground. In the control signal system, the gate terminal of the gate resistance switching pMOS 33a and the gate terminal of the gate resistance switching pMOS 33b are connected to the control terminal of the main circuit current detection circuit 50. Further, the base terminal of the npn transistor 34 and the base terminal of the pnp transistor 35 are connected to the control terminal of the drive logic circuit 36, and the signal input terminal of the drive logic circuit 36 is connected to the control circuit 40.

In the circuit configuration explained above, the drive logic circuit 36 receives a drive signal (for example, PWM signal) from the control circuit 40, and alternately performs switching operation of the npn transistor 34 and the pnp transistor 35. Then, the npn transistor 34 and the pnp transistor 35 amplify the drive signal (for example, PWM signal) of the drive logic circuit 36, and perform switching drive (for example, PWM driving) of the Si-IGBT 12 of the lower arm.

The circuit configuration of the upper arm drive/control circuit 20a is the same as the circuit configuration of the lower arm drive/control circuit 30a, and therefore, repeated explanation thereabout is omitted.

More specifically, as shown in Fig. 9, the inverter device 1c according to the third embodiment of the present invention switches the gate resistance value of the Si-IGBT 12 of the lower arm to three levels, and therefore, the inverter device 1c according to the third embodiment of the present invention is provided with the gate resistance switching pMOS 33a connected in parallel to the gate resistor 31a and the gate resistance switching pMOS 33b connected in series with the gate resistor 31b. Likewise, the inverter device 1c according to the third embodiment of the present invention is provided with the gate resistance switching pMOS 23a connected in parallel to the gate resistor 21a and the gate resistance switching pMOS 23b connected in series with the gate resistor 21b in order to switch the gate resistance value of the Si-IGBT 11 of the upper arm to three levels. The other constituent elements are the same as those of the inverter device 1b according to the second embodiment as shown in Fig. 7.

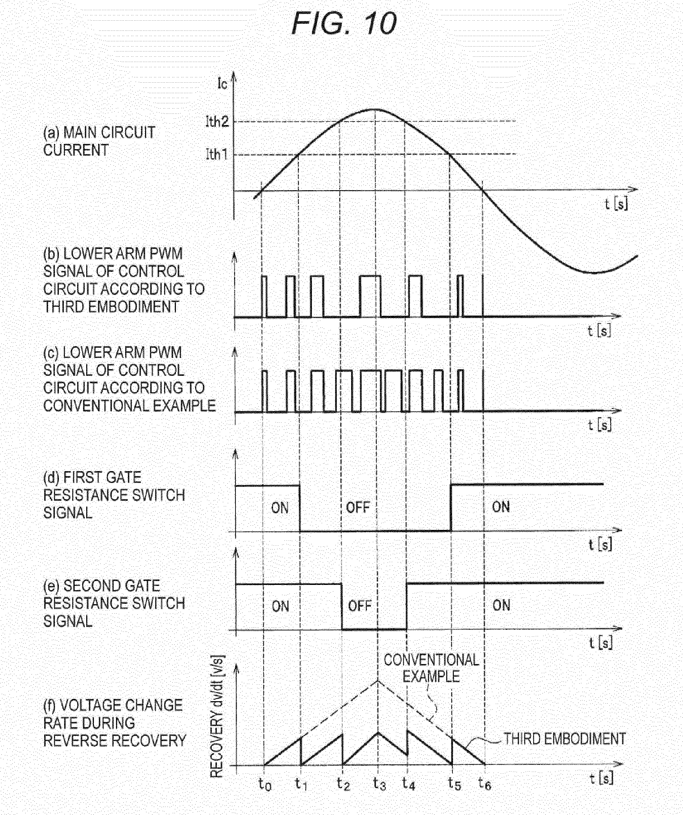

Figs. 10 (a) to 10 (f) are waveform diagrams of units illustrating operation of the inverter device according to the third embodiment of the present invention. Fig. 10(a) shows the main circuit current. Fig. 10(b) shows a lower arm PWM signal of the control circuit according to the third embodiment. Fig. 10 (c) shows a lower arm PWM signal of the control circuit according to the conventional example. Fig. 10(d) shows a first gate resistance switch signal of the lower arm which the main circuit current detection circuit 50 transmits to the gate terminal of the gate resistance switching pMOS 33a in accordance with whether the main circuit current is more than a first threshold value or not. Fig. 10 (e) shows a second gate resistance switch signal of the lower arm which the main circuit current detection circuit 50 transmits to the gate terminal of the gate resistance switching pMOS 33b in accordance with whether the main circuit current is more than a second threshold value or not (however, second threshold value > first threshold value). Fig. 10(f) illustrates a voltage change rate (recovery dv/dt) during reverse recovery of the unipolar type diode 14 of the lower arm. In any of the drawings, the horizontal axis represents a time, and the vertical axis represents the level of each of them. The main circuit current (a) is represented in such a manner that the direction of the current (collector current Ic) flowing from a load not shown via the main circuit 19 and flowing from the collector to the emitter of the Si-IGBT 12 is denoted as the positive terminal. Further, the lower arm PWM signal (b) of the control circuit according to the third embodiment and the lower arm PWM signal (c) of the control circuit according to the conventional example are signals provided via the drive logic circuit 36 to the gate portion of the Si-IGBT 12 of the lower arm in order to generate the main circuit current (a).

When the main circuit current (a) of the sine wave starts to increase from zero at a time t0 in Fig. 10 (a) to 10 (f), the voltage change rate (f) during reverse recovery of the unipolar type diode 14, i.e., the recovery dv/dt, also increases. At this occasion, in a case where the main circuit current (a) detected by the main circuit current detection current transformer 18 is less than a first threshold value Ith1 (for example, 1/3 of the peak value of the main circuit current), the main circuit current detection circuit 50 transmits the ON signal to the control terminal of each of the gate resistance switching pMOSes 33a, 33b. More specifically, both of the first gate resistance switch signal (d) and the second gate resistance switch signal (e) are in the ON state. Accordingly, the resistance value between the collector terminal of the npn transistor 34 and the positive terminal of the lower arm drive/control circuit power supply 37 is zero, and accordingly, the gate resistance value of the Si-IGBT 12 of the lower arm of the inverter main circuit 10 is only the resistance value of the gate resistance 12g.

Then, at a time t1, when the main circuit current (a) detected by the main circuit current detection current transformer 18 is more than the first threshold value Ith1 (for example, 1/3 of the peak value of the main circuit current), the main circuit current detection circuit 50 transmits the OFF signal to the control terminal of the gate resistance switching pMOS 33a while the main circuit current detection circuit 50 keeps on transmitting the ON signal to the control terminal of the gate resistance switching pMOS 33b. More specifically, the first gate resistance switch signal (d) is in the OFF state, and the second gate resistance switch signal (e) is in the ON state.

Therefore, the gate resistance value of the Si-IGBT 12 of the lower arm is a summation of the resistance value of the gate resistance 12g and a resistance value obtained by connecting the gate resistor 31a and the gate resistor 31b in parallel because the gate resistance switching pMOS 33a is in the OFF state and the gate resistance switching pMOS 33b is in the ON state. The gate resistance value after the time t1 is more than the gate resistance value during the time t0 to t1. Accordingly, the current change rate (di/dt) decreases when the Si-IGBT 12 is turned ON, and the voltage change rate (f) during reverse recovery of the unipolar type diode 14 connected in an antiparallel manner, i.e., the recovery dv/dt decreases from the level indicated by a broken line in Fig. 10(f) (the level of the conventional example) to the level indicated by a solid line (the level of the third embodiment) after the time t1. As a result, the ringing of the collector current Ic of the Si-IGBT 12 can be reduced.

Further, at the time t2, when the main circuit current (a) detected by the main circuit current detection current transformer 18 is more than the second threshold value Ith2 (for example, 2/3 of the peak value of the main circuit current), the main circuit current detection circuit 50 transmits the OFF signal to the control terminal of the gate resistance switching pMOS 33b while the main circuit current detection circuit 50 keeps on transmitting the OFF signal to the control terminal of the gate resistance switching pMOS 33a. More specifically, the first gate resistance switch signal (d) is in the OFF state, and the second gate resistance switch signal (e) is in the OFF.

Therefore, the gate resistance value of the Si-IGBT 12 of the lower arm is a summation of the resistance value of the gate resistance 12g and the resistance value of the gate resistor 31a because both of the gate resistance switching pMOS 33a and the gate resistance switching pMOS 33b are in the OFF state. Therefore, the gate resistance value after the time t2 is more than the gate resistance value during the time t1 to t2. Therefore, after the time t2, the current change rate (di/dt) becomes still smaller when the Si-IGBT 12 is turned ON. More specifically, after the time t2, the voltage change rate (e) during reverse recovery of the unipolar type diode 14, i.e., the recovery dv/dt, further decreases. Therefore, the surge voltage (ringing voltage) of the inverter device 1c can be further reduced.

From the time t2 to the time t3, the recovery dv/dt increases as the main circuit current (a) increases, and the gate resistance value of the Si-IGBT 12 is a summation of the resistance value of the gate resistor 31a and the resistance value of the gate resistance 12g. Therefore, the recovery dv/dt according to the third embodiment as indicated by the solid line of Fig. 10 (f) is a value much smaller than the recovery dv/dt according to the conventional example indicated by the broken line.

Subsequently, from the time t3 to the time t4, the voltage change rate (f) during the reverse recovery, i.e., the recovery dv/dt, also decreases as the main circuit current (a) decreases, and when the main circuit current (a) becomes less than the second threshold value Ith2 (for example, 2/3 of the peak value of the main circuit current) at the time t4, then the main circuit current detection circuit 50 transmits the ON signal to the control terminal of the gate resistance switching pMOS 33b while the main circuit current detection circuit 50 keeps on transmitting the OFF signal to the control terminal of the gate resistance switching pMOS 33a. More specifically, the first gate resistance switch signal (d) is in the OFF state, and the second gate resistance switch signal (e) is in the ON state.

Therefore, the gate resistance value of the Si-IGBT 12 of the lower arm is a summation of the resistance value of the gate resistance 12g and a resistance value obtained by connecting the gate resistor 31a and the gate resistor 31b in parallel because the gate resistance switching pMOS 33a is in the OFF state and the gate resistance switching pMOS 33b is in the ON state. The gate resistance value after the time t4 is less than the gate resistance value during the time t3 to t4. Therefore, after the time t4, the recovery dv/dt according to the third embodiment decreases at the level indicated by the solid line (level of the third embodiment in Fig. 10(f)) which is less than the level of the broken line of the conventional example.

Subsequently, at the time t5, the main circuit current detected by the main circuit current detection current transformer 18 is less than the first threshold value Ith1 (for example, 1/3 of the peak value of the main circuit current), and therefore, after the time t5, the main circuit current detection circuit 50 transmits the ON signal to the gate resistance switching pMOS 33a and the gate resistance switching pMOS 33b. More specifically, both of the first gate resistance switch signal (d) and the second gate resistance switch signal (e) are in the ON state. Therefore, the gate resistance value of the Si-IGBT 12 of the lower arm of the inverter main circuit 10 is only the resistance value of the gate resistance 12g because both of the gate resistance switching pMOS 33a and the gate resistance switching pMOS 33b are in the ON state. The gate resistance value after the time t5 is less than the gate resistance value during the time t4 to t5. Therefore, when the main circuit current (a) is equal to or less than the first threshold value Ith1, the voltage change rate (f) during the reverse recovery of the unipolar type diode 14, i.e., the recovery dv/dt, decreases to the same value as that of the conventional example, and at this occasion, the main circuit current (a) is small, and accordingly, the recovery dv/dt is also small, and therefore, the surge voltage (ringing voltage) would not occur in the inverter device 1c.

More specifically, as shown in Fig. 9 explained above, in a case where the gate resistance value is fixed like the conventional example, and a large current flows in the power semiconductor switching element, the recovery dv/dt of the unipolar type diode connected in an antiparallel manner is large. For this reason, a large oscillation current occurs in the collector current Ic as shown in Fig. 6(b-2). However, in the case of the third embodiment of the present invention, the gate resistance is increased to three levels when the current of the power semiconductor switching element increases, and therefore, the recovery dv/dt of the unipolar type diode 14 can be reduced to lower levels in a more detailed manner. Therefore, a large oscillation current would not occur in the collector current Ic like Fig. 6(a-2). The recovery dv/dt is decreased in this manner, and the radiation noise generated by the inverter device 1c is decreased, so that a long life span of the insulation resistance of a motor can be realized.

In other words, the gate resistance value is changed to multiple steps, whereby the recovery dv/dt of the unipolar type diode is controlled in multiple steps, so that the dependency of the recovery dv/dt upon the main circuit current can be decreased in details. Therefore, even when the main circuit current changes, the recovery dv/dt can be maintained at a more flat value, and accordingly, the radiation noise generated by the inverter device 1c is decreased, and a long life span of the insulation resistance of a motor can be realized.

A combination of a gate resistance switching pMOS and a gate resistance in series (for example, the combination of the gate resistance switching pMOS 33b and the gate resistor 31b in series) is provided in multiple levels for a set of a combination of a gate resistance switching pMOS and a gate resistance in parallel (for example, the combination of the gate resistance switching pMOS 33a and the gate resistor 31a in parallel), so that the resistance value of the gate resistance can be changed to multiple levels.

Further, the third embodiment of the present invention is similar to the second embodiment in that the main circuit current detection circuit 50 transmits detection information about the main circuit current detected by the main circuit current detection current transformer 18 to the control circuit 40. Therefore, when the detection value of the main circuit current is large, the control circuit 40 decreases the number of pulses of the PWM signal which are output to the drive logic circuits 26, 36.

This will be explained in more details. As shown in Fig. 10 (a) to 10 (f), in a period when the main circuit current (a) is smaller than the first threshold value Ith1 (time t0 to t1, and time t5 to t6), the lower arm PWM signal (b) of the control circuit according to the third embodiment is the same number of pulses as that of the lower arm PWM signal (c) of the control circuit according to the conventional example, and the number of pulses of the PWM signal is not decreased. Then, in a period when the main circuit current (a) is more than the first threshold value Ith1 but is less than the second threshold value Ith2 (time t1 to t2, and time t4 to t5), the number of pulses of the lower arm PWM signal (b) of the control circuit according to the third embodiment is decreased to a number slightly less than the lower arm PWM signal (c) of the control circuit according to the conventional example.

Further, in a period when the main circuit current (a) is more than the second threshold value Ith2 (time t2 to t4), the number of pulses of the lower arm PWM signal (b) of the control circuit according to the third embodiment is decreased more greatly as compared with the lower arm PWM signal (c) of the control circuit according to the conventional example.

More specifically, in general, when the gate resistance value is increased in a case where the main circuit current is large, the switching loss of the power semiconductor switching element increases, but when the main circuit current is large, the number of pulses of the PWM signal which are output from the control circuit 40 is decreased like the present embodiment, so that the switching loss of the power semiconductor switching element can be reduced. In addition, the number of pulses of the PWM signal can be decreased to three levels in accordance with the magnitude of the main circuit current. For this reason, in the inverter device to which the present embodiment is applied, the radiation noise generated by the inverter device is decreased, so that a long life span of the insulation resistance of a motor can be realized, and the switching loss of the inverter device can be decreased in more details in accordance with the magnitude of the main circuit current.

### «Summary»

As explained above, the inverter device according to the present invention is an inverter device in which the power semiconductor switching element and the unipolar type diode are connected in an antiparallel manner, and when the main circuit current is more than the predetermined value, the recovery dv/dt of the unipolar type diode is suppressed by increasing the gate resistance value of the gate drive circuit that drives the power semiconductor switching element, and therefore, the turn ON loss, the recovery loss, and the noise due to ringing can be decreased. When the main circuit current is more than the predetermined value, the switching loss can be decreased by reducing the number of times of switching the PWM control is performed on the power semiconductor switching element.

This will be explained in more details. Schottky-Barrier diode (SBD) which is a wide gap semiconductor such as SiC, i.e., the unipolar type diode is used as the return current diode of the inverter device, and the turn ON loss and the recovery loss is reduced, the breakdown voltage is increased. At this occasion, the recovery dv/dt of the unipolar type diode increases in proportion to the current value, and therefore, in a case where the main circuit current is more than a predetermined value, the gate resistance value (gate impedance) of the power semiconductor switching element is increased. Therefore, even when the main circuit current is more than the predetermined value, ringing of the collector current of the power semiconductor switching element is suppressed, and the radiation noise generated by the inverter can be reduced. As a result, a long life span of the insulation resistance of a motor, which is a load of the inverter device, can be realized. In a case where the main circuit current is more than the predetermined value, the radiation noise can be reduced and the switching loss of the inverter device can be reduced by decreasing the number of pulses of the PWM signal for driving the inverter device. In other words, the inverter device can be provided, which suppresses ringing caused by the recovery dv/dt and reduces the switching loss.

In this case, current detection means stated in claims is achieved with the main circuit current detection current transformer (CT) 18 and the main circuit current detection circuit 50. Gate impedance is gate resistors 11g, 12g, 21, 22, 21a, 21b, 31, 32, 31a, 31b, and gate impedance switch means can be achieved with the gate resistance switching pMOSes 23, 23a, 23b, 33, 33a, 33b. Further, switching number reduction means is achieved with an internal function of the control circuit 40 generating the PWM signal.

The power semiconductor switching element is made using materials such as silicon (Si), silicon carbide (SiC), gallium nitride (GaN), or diamond, and is achieved as a power semiconductor device such as an insulated gate bipolar transistor (IGBT), a junction field effect transistor (JFET), and a metal oxide semiconductor field effect transistor (MOSFET).

Further, the unipolar type diode is made of a wide gap semiconductor such as Si, SiC, GaN, or diamond, and is achieved as, for example, a Schottky-Barrier diode (SBD). The SBD has such characteristic that the recovery dv/dt increases in proportion to the current value.

The embodiments of the inverter device according to the present invention have been hereinabove explained in a specific manner. It is to be understood that the present invention is not limited to the contents of the embodiments explained above, and can be changed in various manners without deviating from the gist thereof. In other words, the embodiments explained above are shown in detail as an example for explaining the contents of the present invention in an easy to see manner, and are not necessarily limited to those having all the configurations explained above. Some of the configurations of any given embodiment may be replaced with configurations of another embodiment, and further, configurations of another embodiment may be added to the configurations of any given embodiment. For example, instead of switching the gate resistance value so as to increase the gate resistance value in a stepwise manner in accordance with the increase in the main circuit current of the inverter device, the gate resistance value may be continuously changed so that the gate resistance value is increased in accordance with the increase of the main circuit current.

### Industrial Applicability

According to the inverter device of the present invention, the turn ON loss and the switching loss of the power semiconductor switching element can be reduced, and the recovery loss of the return current diode can be reduced, and the switching noise can be reduced, and therefore, the inverter device of the present invention, can be effectively used as various kinds of equipment which require a high quality power supply.

### Reference Signs List

1a, 1b, 1c inverter device
10 inverter main circuit
11, 12 Si-IGBT (power semiconductor switching element)
11g, 12g, 21, 22, 21a, 21b, 31, 32, 31a, 31b gate resistance/gate resistor (gate impedance)
13, 14 unipolar type diode
15 main circuit power supply
16, 17 main circuit inductor
18 main circuit current detection current transformer (current detection means)
19 main circuit
20, 20a upper arm drive/control circuit
23, 23a, 23b, 33, 33a, 33b gate resistance switching pMOS (gate impedance switch means)
24, 34 npn transistor
25, 35 pnp transistor
26, 36 drive logic circuit
27, 28, 37, 38 drive/control circuit power supply
30, 30a lower arm drive/control circuit
40 control circuit (switching number reduction means)
50 main circuit current detection circuit (current detection means)
51 control signal line

## Claims

1. An inverter device comprising a power semiconductor module in which a power semiconductor switching element and a unipolar type diode are connected in an antiparallel manner,
the inverter device comprising:
current detection means configured to detect a current flowing in the power semiconductor module; and
gate impedance switch means configured to switch gate impedance so as to increase the gate impedance of a gate drive circuit for driving the power semiconductor switching element when a current value detected by the current detection means is more than a predetermined value.

2. The inverter device according to claim 1, wherein the power semiconductor switching element performs PWM control, and
the inverter device further comprising switching number reduction means configured to reduce a number of switching of the PWM control when the current value detected by the current detection means is more than a predetermined value.

3. The inverter device according to claim 1 or 2, wherein the gate impedance switch means changes the gate impedance to two or more levels in accordance with the magnitude of the current value detected by the current detection means.

4. The inverter device according to claim 2 or 3, wherein the switching number reduction means changes the number of switching of the PWM control to two or more levels in accordance with the magnitude of the current value detected by the current detection means.

5. The inverter device according to any one of claims 1 to 4, wherein the power semiconductor switching element is made using at least one of materials including silicon, silicon carbide, gallium nitride, and diamond.

6. The inverter device according to claim 5, wherein the power semiconductor switching element is any one of an insulated gate bipolar transistor, a junction field effect transistor, and a metal oxide semiconductor field effect transistor.

7. The inverter device according to any one of claims 1 to 6, wherein the unipolar type diode is made using a wide gap semiconductor made using at least one of materials including silicon, silicon carbide, gallium nitride, and diamond.

8. The inverter device according to claim 7, wherein the unipolar type diode is a Schottky-Barrier diode of which voltage change rate during reverse recovery increases in proportion to a current value.
